# EUROPÄISCHE PATENTANMELDUNG

(11) **EP 2 251 762 A2**
(43) Veröffentlichungstag der Anmeldung: **17.11.2010**
(21) Anmeldenummer: 10162763.6
(22) Anmeldetag: 12.05.2010
(51) Int. Cl.: G05G 1/10

(54) **Bedienvorrichtung für ein Elektrogerät**

(30) Priorität: 14.05.2009 DE 102009022339
(71) Anmelder: E.G.O. Elektro-Gerätebau GmbH, 75038 Oberderdingen (DE)
(72) Erfinder: Herweg, Elmar, 75038 Oberderdingen (DE)
(74) Vertreter: Patentanwälte Ruff, Wilhelm, Beier, Dauster & Partner

(57) **Zusammenfassung**

Eine Bedienvorrichtung (11) für ein Elektrogerät weist eine Bedieneinheit (13) als Drehregler auf, die an einer Blende bzw. Auflagefläche (16) des Elektrogeräts drehbeweglich und abnehmbar gehaltert ist. An der Oberseite der Bedieneinheit (13) sind mehrere kapazitive Berührungsschalter (26a,26b) als Schaltmittel und mindestens eine Anzeige (34) vorgesehen. Die Oberseite (23) ist im wesentlichen lichtdurchlässig im Bereich des Berührungsschalters (26a,26b) und der Anzeige (34) und kann von einer Deckscheibe aus Mineralglas gebildet sein.

## Beschreibung

### Anwendungsgebiet und Stand der Technik

Die Erfindung betrifft eine Bedienvorrichtung für ein Elektrogerät mit einer Bedieneinheit als Dreh- oder Schieberegler, die an einer Blende bzw. Auflagefläche des Elektrogeräts bzw. der Bedienvorrichtung beweglich und/oder abnehmbar gehaltert ist. Dabei kann sie gedreht und/oder verschoben werden.

Aus der EP 1775650 A2 ist eine solche Bedienvorrichtung bekannt. Ein Drehregler als Bedieneinheit weist an seiner Oberseite einen kapazitiven Berührungsschalter auf.

### Aufgabe und Lösung

Der Erfindung liegt die Aufgabe zugrunde, eine eingangs genannte Bedienvorrichtung zu schaffen, mit der Probleme und Nachteile des Standes der Technik vermieden werden können und insbesondere erweiterte Bedienfunktionen möglich sind.

Gelöst wird diese Aufgabe durch eine Bedienvorrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

An der Oberseite der Bedieneinheit ist mindestens ein Berührungsschalter als Schaltmittel vorgesehen, und zwar vorteilhaft als kapazitiver Berührungsschalter. Ein solcher ist eben grundsätzlich aus der vorgenannten EP 1 775 650 A2 bekannt sowie auch aus der EP 859 467 A und EP 859 468 A.

Erfindungsgemäß weist die Oberseite zumindest im Bereich des Berührungsschalters eine lichtdurchlässige Oberseite und/oder eine nicht elektrisch-leitfähige Oberseite auf. So ist es möglich, darunter sowohl kapazitive Berührungsschalter als auch Leuchtanzeigen vorzusehen.

Besonders vorteilhaft weist die Oberseite zumindest im Bereich des Berührungsschalters eine durchsichtige Abdeckung odgl. bzw. eine Scheibe auf, die aus Mineralglas besteht. Dies bedeutet also, dass in vorteilhafter Weise der Berührungsschalter an der Unterseite einer solchen Mineralglasabdeckung bzw. entsprechenden Scheibe vorgesehen ist.

Es hat sich im Rahmen der Erfindung herausgestellt, dass eine solche Abdeckung bzw. Scheibe aus Mineralglas erhebliche Vorteile gegenüber sonstigen, für ähnliche Abdeckungen verwendeten Kunststoffmaterialien aufweist. Nicht nur weil Glas kratzfest ist und leicht zu reinigen, sondern vor allem weil eine gegenüber Kunststoff erheblich größere Dielektrizitätszahl von Glas für die Verwendung eines kapazitiven Berührungsschalters an der Bedieneinheit signifikante Vorteile bringt. Es ist dadurch bei Auflegen eines Fingers einer Bedienperson eine erheblich höhere sogenannte Betätigungskapazität erreichbar, welche die Auswertung einer Bedienung erheblich verbessert durch den deutlich vergrößerten Signalhub. Als Glas bieten sich unterschiedliche Gläser an, insbesondere mit gehärteter Oberfläche bzw. gehärtete Gläser für noch bessere Kratzbeständigkeit sowie für eine lange Lebensdauer. Das Mineralglas sollte so gewählt werden, dass seine Dielektrizitätszahl möglichst groß ist.

In vorteilhafter Ausgestaltung der Erfindung ist eine einzige Scheibe bzw. Abdeckung aus Mineralglas an der Oberseite der Bedieneinheit vorgesehen. Sie kann beispielsweise einen Großteil der Oberseite bedecken, vorteilhaft mehr als die Hälfte. Besonders vorteilhaft bedeckt die Scheibe sogar mehr als 70%. Sie kann bereichsweise lichtdurchlässig und lichtundurchlässig ausgebildet sein, wobei eine Lichtdurchlässigkeit im Bereich einer später noch erläuterten Anzeige empfehlenswert ist und im Bereich des Berührungsschalters eher vermieden werden sollte. Das Glas kann transparent oder auch eingefärbt sein. Dekorschichten, Kennzeichnungen odgl. können sowohl an der Unterseite als auch an der Oberseite vorgesehen sein, beispielsweise an der Oberseite zur Kennzeichnung des Berührungsschalters.

Vorteilhaft kann in einer einfachen Ausgestaltung der Erfindung die Oberseite bzw. eine Scheibe aus Mineralglas den größten Teil der Oberseite der Bedieneinheit bedecken und bis zu einer Randumfassung verlaufen. Eine Scheibe ist besonders vorteilhaft auch flach ausgebildet. Die Randumfassung kann vorteilhaft ein einziges Bauteil sein, insbesondere ein umlaufender Ring, so dass die Bedieneinheit die Form einer dicken Scheibe oder eines dicken Knebels erhält. Als Material für die Randumfassung kann Metall verwendet werden, insbesondere Aluminium oder Edelstahl. Die Oberseite kann damit direkt verklebt werden.

In einer weiteren Ausgestaltung der Erfindung ist mindestens eine Anzeige an der Oberseite der Bedieneinheit vorgesehen, insbesondere eine Leuchtanzeige. In vorteilhafter Ausgestaltung der Erfindung kann auch im Bereich einer genannten Anzeige die Scheibe bzw. Abdeckung aus Mineralglas vorgesehen sein, besonders vorteilhaft als durchgängige Abdeckung bzw. Scheibe, die die wesentliche Oberseite bedeckt.

Für den kapazitiven Berührungsschalter sind Sensorelemente vorgesehen, die in vorteilhafter Ausgestaltung der Erfindung als elektrisch leitfähige Flächen an der Unterseite der Scheibe bzw. Abdeckung aus Mineralglas vorgesehen sind. Besonders vorteilhaft sind sie unlösbar daran befestigt, insbesondere angeklebt oder als Beschichtung aufgebracht. Diese Sensorelemente sind mit elektrisch leitfähigen Verbindungen mit Flächen an einer Bodenabdeckung der Bedieneinheit verbunden, insbesondere einer Bodenplatte. Diese Flächen sind auf deren Oberseite vorgesehen und verlaufen vorteilhaft im wesentlichen parallel zu der Blende bzw. Auflagefläche des Elektrogeräts bzw. der Bedienvorrichtung. In einer möglichen Ausgestaltung der Erfindung kann auch die Bodenabdeckung eine Scheibe sein, die beispielsweise mit einer vorbeschriebenen Randumfassung fest verbunden bzw. verklebt ist.

Solche elektrisch leitfähigen Verbindungen können entweder angelötete oder befestigte Drähte oder dergleichen sein. Alternativ können es feste Körper sein, beispielsweise elastische Metallfedern oder elektrisch leitfähige Kunststoffkörper.

In weiterer vorteilhafter Ausgestaltung der Erfindung ist es möglich, für die Sensorelemente für die kapazitiven Berührungsschalter in der Bedieneinheit elastische, elektrisch leitfähige Sensorelementkörper vorzusehen, die an die Unterseite der Scheibe bzw. Abdeckung aus Mineralglas angelegt sind, insbesondere dagegen gedrückt sind. Des weiteren können sie vorteilhaft auch an der Oberseite einer vorbeschriebenen Bodenabdeckung anliegen, insbesondere dazwischen eingespannt sein. Durch die dadurch erzeugte Druckspannung ist ihre Position vorgegeben und vor allem ist, entsprechend der eingangs genannten EP 859 467 A, eine genau definierte Anlage der Oberseite eines solchen Sensorelementkörpers, die dann das kapazitive Sensorelement bzw. dessen Fläche bildet, an der Unterseite des Glases gegeben. Solche Sensorelementkörper können eben, wie in der genannten EP 859 467 beschrieben, aus elektrisch leitfähigem Kunststoff bestehen. Zusätzlich zu der kapazitiven Sensorelementfläche können sie auch die vorbeschriebene Fläche an der Bodenabdeckung bilden für eine kapazitive Übertragung eines Signals durch die Bodenabdeckung und die genannte Blende bzw. Auflagefläche hindurch wie entsprechende weitere kapazitive Sensorelemente, die mit einer Ansteuerung und Auswertung verbunden sind. Alternativ zu Sensorelementkörpern aus elektrisch leitfähigem Kunststoff können solche elastisch bzw. federnd und aus Metall vorgesehen sein, beispielsweise auch mit größeren Flächen unten und oben und einer Federkonstruktion dazwischen.

Eine Randumfassung kann zumindest teilweise lichtdurchlässig sein, und dazu insbesondere aus mehreren Materialien zusammengesetzt sein. Vorteilhaft kann sie im wesentlichen aus einem metallischen Ring und lichtdurchlässigen Einsätzen aus Kunststoff bestehen, die nach Art von Fenstern in die Randumfassung eingesetzt sind. Die lichtdurchlässigen Einsätze können sich auch nach Art von Lichtleitern in das Innere hinein und zu der Unterseite der Bedieneinheit hinziehen, um dort durch einen lichtdurchlässigen Boden eingestrahltes Licht zur Seite hin umzuleiten, so dass es an der Randumfassung austritt bzw. dort leuchtend erkennbar ist. Dazu können unterhalb der Blende bzw. Auflagefläche des Elektrogeräts Lichtquellen vorgesehen sein, vorzugsweise LED mit Leuchtrichtung nach oben. Auf ähnliche Art und Weise kann von unten eingekoppeltes Licht auch an der Oberseite austreten, wobei auch hier vorteilhaft Lichtleiter verwendet werden können, die von der Unterseite der Bedieneinheit zur Oberseite verlaufen können. Es kann natürlich auch die gesamte Bedieneinheit von innen beleuchtet werden durch Einstrahlen von unten und Herausleuchten an Leuchtfenstern am Rand und/oder der Oberseite.

In Weiterbildung der Erfindung können in der Bedieneinheit zusätzlich Beschleunigungssensoren vorgesehen sein, die zur Erkennung einer Drehbewegung oder Schiebebewegung ausgebildet sind. Dadurch kann zusätzlich oder alternativ zu kapazitiven Sensoren, die über Berührung beispielsweise an der Randumfassung die Drehbewegung oder Schiebebewegung erkennen, eine solche Bewegung erkannt und ausgewertet werden.

Wie in der DE 102 12 954 A1 beschrieben, kann der Knebel über eine aktive Elektronik verfügen. Somit kann eine Auswerteelektronik zur Kapazitätsänderung auch in der Bedieneinheit selbst enthalten sein. Weiterhin kann eine aktive Elektronik im Knebel über einen Verstärker verfügen, der das Signal der Kapazitätsänderung elektrisch verstärkt, so daß die Auswertung der Kapazitätsänderung nicht zwingend im Knebel erfolgen muss. Eine Energieversorgung der Elektronik kann induktiv von unterhalb der Auflagefläche erfolgen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigt:
- Fig. 1: einen Schnitt durch eine Ausbildung einer erfindungsgemä- ßen Bedienvorrichtung mit Bedieneinheit als Drehregler,
- Fig. 2: eine Draufsicht auf die Bedieneinheit aus Fig. 1 und
- Fig. 3: einen Schnitt durch eine alternative Ausbildung einer erfin- dungsgemäßen Bedienvorrichtung ähnlich Fig. 1.

### Detaillierte Beschreibung der Ausführungsbeispiele

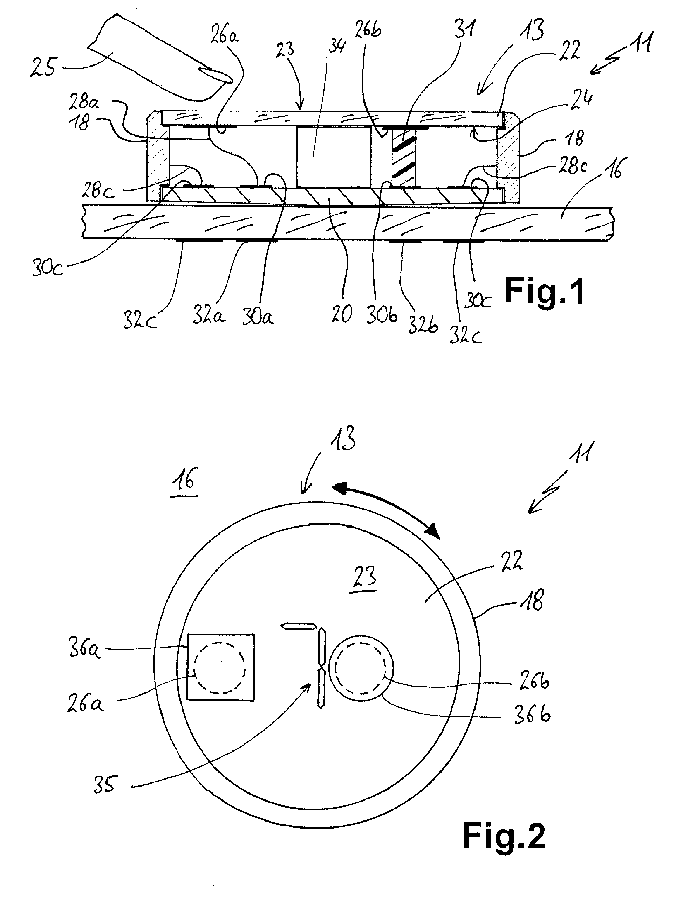

In Fig. 1 ist im seitlichen Schnitt und in Fig. 2 in Draufsicht eine erfindungsgemäße Bedienvorrichtung 11 dargestellt. Die Bedienvorrichtung 11 kann beispielsweise direkt an einem Elektrogerät zu dessen Bedienung vorgesehen sein, wozu sie eine Bedieneinheit 13 aufweist, die als Drehregler entsprechend der EP 1 775 650 A2 ausgebildet ist. Sie liegt auf einer Auflagefläche 16 auf, welche beispielsweise ein Glaskeramik-Kochfeld eines Elektrokochfeldes ist. Die Bedieneinheit 13 weist vom konstruktiven Aufbau her eine umlaufende Randumfassung 18 auf, die insbesondere als breiter Ring ausgebildet ist und aus Metall bzw. Edelstahl bestehen kann. Unten ist an der Randumfassung 18 eine Bodenplatte 20 eingelassen, vorteilhaft aus Kunststoff. Oben weist sie eine Deckscheibe 22 auf, die bevorzugt als flache Glasscheibe aus Mineralglas ausgebildet ist, aber auch aus Kunststoff bestehen kann. Die gesamte Bedieneinheit 13 kann allgemein wasserdicht ausgebildet sein, evtl. durch seitliche Dichtungen oder Verklebungen.

Die Deckscheibe 22 weist eine Oberseite 23 auf, auf welche ein Finger 25 aufgelegt werden kann, wie nachfolgend noch näher erläutert wird, sowie eine Unterseite 24. An der Unterseite 24 sind zwei Sensorelemente 26a und 26b vorgesehen, insbesondere als elektrisch leitfähige Beschichtungen oder dünne, daran befestigte Metallplättchen. Diese Sensorelemente 26a und 26b arbeiten als kapazitive Berührungsschalter. Sie können gemäß dem in der DE 10 2006 026 187 A1 oder der EP 859 467 A1 beschriebenen Funktionsprinzip arbeiten, wobei diesbezüglich der Inhalt der genannten Schriften durch ausdrückliche Bezugnahme zum Inhalt der vorliegenden Beschreibung gemacht wird.

Zur Signalankopplung an eine nicht dargestellte Steuereinrichtung unter der Auflagefläche 16 sind elektrische Verbindungen 28a und 28c sowohl von den Sensorelementen 26a und 26b als auch von der metallischen und somit elektrisch leitfähigen Randumfassung 18 vorgesehen, die an obere Übertragerflächen 30a bis 30c an der Bodenplatte 20 reichen. Die elektrischen Verbindungen 28 können dabei als angelötete oder elektrisch leitfähig festgeklebte Drähte, Metallfedern odgl. ausgebildet sein. Eine weitere mögliche Ausbildung einer elektrischen Verbindung ist ein elektrisch leitfähiger, elastischer und volumenveränderlicher Kunststoffkörper 31, der zwischen Sensorelement 26b und oberer Übertragerfläche 30b eingespannt ist und diese somit ebenfalls elektrisch leitfähig verbindet. Hier kann sogar in Erweiterung vorgesehen sein, das obere Sensorelement 26 und/oder die obere Übertragerfläche 30 am Kunststoffkörper 31 einzusparen, da dessen jeweils anliegende Stirnseiten entsprechend der EP 859 467 A als gleich wirkende Flächen funktionieren können.

An der Unterseite der Auflagefläche 16 sind untere Übertragerflächen 32a bis 32c vorgesehen, und zwar genau gegenüber den oberen Übertragerflächen 30. Diese unteren Übertragerflächen 32 sind auf an sich bekannte Art und Weise mit einer Ansteuerung und/oder Auswertung bzw. Steuerung der Bedienvorrichtung 11 oder des gesamten Elektrogerätes verbunden, siehe insbesondere die EP 1775650 A2. An den unteren Übertragerflächen 32 kann nach Anlegen eines Signals erfasst werden, ob ein Finger 25 auf die Oberseite 23 der Deckscheibe 22 über einem Sensorelement 26a oder b aufgelegt worden ist bzw. ob die Randumfassung 18 berührt worden ist, beispielsweise zum Drehen bzw. Bewegen der Bedieneinheit 13.

Eine Auswerteelektronik des Elektrogeräts unter der Auflagefläche 16 zur Auswertung bzw. Bestimmung einer Drehbewegung verfügt über mehrere kapazitive Sensoren in Form der unteren Übertragerflächen 32c, die auf einer Kreisbahn angeordnet sind, siehe wieder insbesondere die EP 1775650 A2, die dann unterhalb der Kreisbahn liegen, die die oberen Übertragerflächen 30c bei der Drehung überdecken bzw. überlaufen. Durch die Drehung des Knebels ändert sich die Kapazität an den unteren Übertragerflächen 32c entsprechend ihrer Überdeckung, da ja durch das Berühren der Randumfassung 18 zum Drehen und die elektrische Verbindung 28c zu den oberen Übertragerflächen 30c eine kapazitive Kopplung unter die Auflagefläche 16 stattfindet. Die Signaländerung wird als eine Drehbewegung interpretiert. Einer Drehrichtung wird so eine Erhöhung oder Reduzierung der Kochstufe zugeordnet. Wird der Knebel losgelassen, so ist die Eingabe abgeschlossen. Eine Randumfassung könnte auch nur in einem oberen Bereich, beispielsweise der Übergangskante zur Oberseite hin, elektrisch leitfähig sein, sei es durch separate Metallteile oder eine dünne metallische oder allgemein elektrisch leitfähige Beschichtung.

Aus Fig. 1 ist zu erkennen, dass die Wahl von Glas bzw. Mineralglas als Material für die Deckscheibe 22 für die kapazitiven Berührungssensoren große Vorteile bringt aufgrund der hohen Dielektrizitätszahl des Glases, so dass sich ein hoher und gut erkennbarer sowie unterscheidbarer Signalhub ergibt.

Des Weiteren ist im Inneren der Bedieneinheit 13 eine Leuchtanzeige 34 vorgesehen, vorteilhaft als Sieben-Segment-Anzeige, die das in Fig. 2 erkennbare Leuchtsymbol 35 erzeugt. Somit sollte also zumindest in diesem Bereich die Deckscheibe 22 im Wesentlichen oder möglichst vollständig lichtdurchlässig sein, damit das Leuchtsymbol 35 gut zu erkennen ist. Im übrigen Bereich, insbesondere an den Sensorelementen 26, sollte sie nicht lichtdurchlässig sein, so dass es sich ein ansprechender optischer Eindruck ergibt.

Eine Energieversorgung der Leuchtanzeige 34 kann von unterhalb der Auflagefläche 16 beispielsweise induktiv erfolgen, siehe hierzu beispielsweise die DE 10212954 A1. Eine Induktionsspule dafür kann auf einer Leiterplatte, die auf der Oberseite der Bodenplatte 20 aufliegt und die beispielsweise die oberen Übertragerflächen 30 trägt, aufgebracht sein. Sie kann auch für die oben genannte Energieversorgung einer Elektronik in der Bedieneinheit verwendet werden.

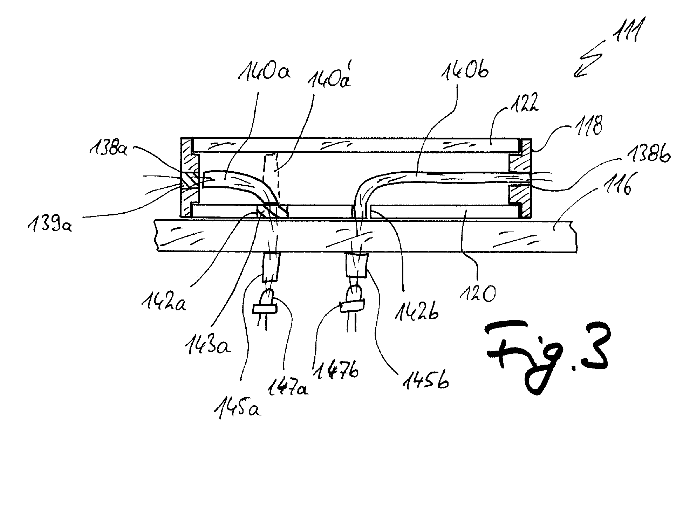

Alternativ kann durch Lichtleiter odgl. Licht von unten durch die Bodenplatte 20 in die Bedieneinheit 13 eingestrahlt werden und dann entsprechend oben herausgeführt sein, sodass eben keine Sieben-Segment-Anzeige vorhanden wäre, sondern nur eine normale Leuchtanzeige. Es wird auf die Fig. 3 verwiesen. Dann sind Auflagefläche 16 und Bodenplatte 20 entsprechend lichtdurchlässig auszubilden, entweder flächig oder zumindest bereichsweise.

Auf der Oberseite 23 der Deckscheibe 22 sind oberhalb der Sensorelemente 26a und 26b Aufdrucke 36a und 36b vorgesehen. Diese sollen einer Bedienperson deutlich machen, wo der Finger 25 für die entsprechende Funktion aufzulegen ist. Die Aufdrucke 36 können des Weiteren auch noch piktogrammartige oder symbolartige Formen aufweisen, aus denen sich ihre Funktion ergibt, beispielsweise Plus- oder Minus-Zeichen odgl..

In Weiterbildung der Erfindung ist es auch möglich, nicht nur die Leuchtanzeige 34 oder Leuchtsymbole vorzusehen, sondern auch einen größeren Bereich der Deckscheibe 22 der Bedieneinheit 13 zu beleuchten. So können beispielsweise auch die Aufdrucke 36 oder entsprechende Symbole beleuchtet sein, möglicherweise auch durch weitere LED.

Die Fig. 3 zeigt im Querschnitt eine Bedienvorrichtung 111 mit leicht abgewandelter Bedieneinheit 113, bei der das in Fig. 1 gezeigte elektrische und funktionale Innenleben auch vorhanden ist, aber der Übersichtlichkeit halber nicht dargestellt ist. Die hier dargestellten Teile im Inneren könnten aber auch sehr gut mit denen zusammen vorhanden sein, die zur Fig. 1 im speziellen sowie allgemein beschrieben worden sind. Zusätzlich dazu weist die Bedieneinheit 113 nämlich verschiedene Möglichkeiten der Beleuchtung auf. Dazu weist die Randumfassung 118 mehrere Durchbrüche 138 auf, beispielsweise links den Durchbruch 138a und rechts den Durchbruch 138b. Im linken Durchbruch 138a ist ein lichtdurchlässiges Kunststoff-Fenster 139a eingelassen, hinter dem ein gebogener Lichtleiter 140a sitzt. Dieser ist auf einem lichtdurchlässigen Kunststoff-Fenster 143a in einem Durchbruch 142a in der Bodenplatte 120 aufgesetzt. Von unten über einen Lichtleitkörper 145a und eine LED 147a eingestrahltes Licht leuchtet so seitlich an dem Kunststoff-Fenster 139a heraus. Eine fakultativ mögliche und deswegen gestrichelte Abzweigung 140a' reicht an die Unterseite der Deckscheibe 122 und leuchtet dort heraus bzw. hindurch. Die LED 147a ist so angeordnet, dass sie nur in bestimmten Drehpositionen bzw. nur in einer einzigen in den Lichtleiter 140a einstrahlen kann. So kann eine bestimmte Position angezeigt werden. Der Lichtleiter zur Oberseite 122 kann auch eigenständig ausgebildet sein ohne Zweig zur Seite hin. Es können noch weitere solche außerzentrischen Lichtleiter vorgesehen sein, die dann alle leuchten, wenn sie die LED 147a überstreichen bzw. darüber liegen.

Rechts ist ein Lichtleiter 140b dargestellt, der direkt in dem Durchbruch 138b sitzt und ähnlich auch in einem Durchbruch 142b in der Bodenplatte 120. Von unten über einen Lichtleitkörper 145b und eine LED 147b eingestrahltes Licht leuchtet so seitlich an dem Lichtleiter 140b aus der Randumfassung 118 heraus. Hier entfallen also die separaten Kunststoff-Fenster. Die LED 147b ist auch an der Drehachse angebracht, so dass unabhängig vom Drehwinkel der Lichtleiter 140b aus der Randumfassung 118 herausleuchtet.

Selbstverständlich können in Erweiterung auch mehr oder weniger LED oder andere Lichtquellen vorgesehen sein.

## Patentansprüche

1. Bedienvorrichtung für ein Elektrogerät mit einer Bedieneinheit als Dreh- oder Schieberegler, wobei die Bedieneinheit als eigenständige Baugruppe, vorzugsweise ohne bewegbare Teile, an einer Blende bzw. Auflagefläche des Elektrogeräts abnehmbar bzw. beweglich gehaltert ist, insbesondere drehbeweglich oder schiebebeweglich, wobei an der Oberseite der Bedieneinheit mindestens ein Berührungsschalter als Schaltmittel vorgesehen ist, **dadurch gekennzeichnet, dass** die Oberseite zumindest im Bereich des Berührungsschalters eine lichtdurchlässige Oberseite und/oder eine nicht elektrisch-leitfähige Oberseite aufweist.

2. Bedienvorrichtung nach Anspruch 1, **dadurch gekennzeichnet, dass** die Oberseite zumindest im Bereich des Berührungsschalters Mineralglas aufweist bzw. von einer Scheibe aus Mineralglas gebildet ist, wobei vorzugsweise das Mineralglas eine möglichst große Dielektrizitätszahl aufweist.

3. Bedienvorrichtung nach Anspruch 2, **dadurch gekennzeichnet, dass** eine einzige Scheibe aus Mineralglas an der Oberseite der Bedieneinheit vorgesehen ist.

4. Bedienvorrichtung nach Anspruch 2 oder 3, dass die lichtdurchlässige Oberseite und/oder nicht elektrisch-leitfähige Oberseite, insbesondere als Scheibe aus Mineralglas, mehr als die Hälfte der Oberseite der Bedieneinheit bedeckt, vorzugsweise mehr als 70%.

5. Bedienvorrichtung nach einem der vorhergehenden Ansprüche, **dadurch gekennzeichnet, dass** die Oberseite ein einziges Bauteil ist, vorzugsweise eine Scheibe, und bis zu einer Randumfassung der Bedieneinheit verläuft.

6. Bedienvorrichtung nach einem der vorhergehenden Ansprüche, **dadurch gekennzeichnet, dass** mindestens eine Anzeige an der Oberseite der Bedieneinheit vorgesehen ist, wobei insbesondere die Scheibe aus Mineralglas nach Anspruch 2 auch im Bereich dieser Anzeige vorgesehen ist.

7. Bedienvorrichtung nach einem der vorhergehenden Ansprüche, **dadurch gekennzeichnet, dass** Sensorelemente für kapazitive Berührungsschalter als elektrisch leitfähige Flächen unten an der Oberseite vorgesehen sind, insbesondere unlösbar daran befestigt sind, wobei diese Sensorelemente mittels elektrisch leitfähiger Verbindungen mit elektrisch leitfähigen Flächen an einer Bodenabdeckung der Bedieneinheit verbunden sind, wobei diese Flächen im wesentlichen parallel zu der Blende bzw. Auflagefläche des Elektrogeräts verlaufen.

8. Bedienvorrichtung nach einem der vorhergehenden Ansprüche, **dadurch gekennzeichnet, dass** für Sensorelemente von kapazitiven Berührungsschaltern in der Bedieneinheit elastische, elektrisch leitfähige Sensorelementkörper vorgesehen sind, die zwischen Unterseite der Scheibe aus Mineralglas und Oberseite einer Bodenabdeckung angeordnet sind, insbesondere unter halternder Druckspannung, wobei vorzugsweise die Sensorelementkörper aus elastischem, elektrisch leitfähigem Kunststoffmaterial bestehen und flächig sowohl an der Unterseite der Scheibe aus Mineralglas anliegen als auch an der Oberseite der Bodenabdeckung.

9. Bedienvorrichtung nach Anspruch 5, **dadurch gekennzeichnet, dass** die Randumfassung ein umlaufender Ring ist, vorzugsweise zumindest bereichsweise elektrisch leitfähig, insbesondere aus Metall bzw. Edelstahl, wobei vorzugsweise die Bereiche elektrischer Leitfähigkeit als Sensorelemente für kapazitive Berührungsschalter.

10. Bedienvorrichtung nach Anspruch 5 oder 9, **dadurch gekennzeichnet, dass** die Randumfassung zumindest teilweise lichtdurchlässig ist, insbesondere aus mehreren Materialien zusammengesetzt ist, vorzugsweise aus einem metallischen Ring und lichtdurchlässigen Einsätzen aus Kunststoff.

11. Bedienvorrichtung nach einem der vorhergehenden Ansprüche, **dadurch gekennzeichnet, dass** in der Bedieneinheit Lichtleiter vorgesehen sind von einer Unterseite zur Randumfassung und/oder zur Oberseite hin, die von unten eingestrahltes Licht leiten und aus der Bedieneinheit wieder herausleiten.

12. Bedienvorrichtung nach einem der vorhergehenden Ansprüche, **dadurch gekennzeichnet, dass** in der Bedieneinheit zusätzlich Beschleunigungssensoren vorgesehen sind, die zur Erkennung einer Drehbewegung oder Schiebebewegung ausgebildet sind.

13. Bedienvorrichtung nach einem der vorhergehenden Ansprüche, **dadurch gekennzeichnet, dass** die Bedieneinheit wasserdicht ausgebildet ist.
